# EUROPEAN PATENT APPLICATION

(11) **EP 4 414 157 A1**
(43) Date of publication of application: **14.08.2024**
(21) Application number: 24153398.3
(22) Date of filing: 23.01.2024
(51) Int. Cl.: B29C 59/16, F28D 15/02, F28D 15/04, B23K 26/362, B23K 26/402, B29C 35/08

(54) **METHOD OF FABRICATING HEAT PIPES AND VAPOR CHAMBERS USING A LASER OR ULTRA-VIOLET PROCESS**

(30) Priority: 10.02.2023 US 202363444635 P; 08.11.2023 US 202318387994
(71) Applicant: Meta Platforms Technologies, LLC, Menlo Park, CA 94025 (US)
(72) Inventor: Vakhshouri, Kiarash, Menlo Park (US)
(74) Representative: Murgitroyd & Company

(57) **Abstract**

Techniques, systems, and arrangements are described herein which provide unique heat pipe fabrication techniques, whereby wettability of surfaces (hydrophilicity and hydrophobicity) of radio frequency (RF) compatible polymers may be modulated and controlled through a laser treatment. For example, using a femtosecond laser with a different dosage (a range of, for example, 50 J/cm² to 100 J/cm²) in an evaporator portion of a heat pipe compared to the condenser portion of a heat pipe (a range of, for example, .25 J/cm² to 45 J/cm²), polymers such as, for example, poly(methyl methacrylate) (PMMA) based polymers, polysulfone (PSF) based polymers, azobenzene, polytetrafluoroethylene, etc., may be chemically altered to have a different surface energy. Additionally, a different focus time of the femtosecond laser may be used in addition to, or instead of, the different dosages of laser energy.

## Description

### TECHNICAL FIELD

The present disclosure describes heat pipes, vapor chambers, thermal spreaders, and other thermal solutions (collectively referred to herein as "heat pipes").

### BACKGROUND

Recent advances in battery technology have enabled computationally powerful portable electronic devices, which generate considerable amounts of heat. The increased heat generated by these devices, coupled with the continual demand for smaller and lighter devices makes it difficult to adequately dissipate heat from the portable electronic devices or to achieve isothermal conditions. Heat pipes and vapor chambers are useful means to spread and/or dissipate heat in an electronic device. However, existing heat pipes and vapor chambers are available in limited sizes, shapes, materials, and configurations, and conventional techniques for manufacturing heat pipes and vapor chambers make their construction complicated, time consuming, and costly.

In particular, processing and creating the right wetting surface for heat pipes and vapor chambers is complex. On the evaporator side of the heat pipes and vapor chambers, hydrophilic surfaces are needed and on the condenser side, hydrophobic/superhydrophobic surfaces are needed for efficient heat transfer. One of the main challenges in heat pipe manufacturing is to have the right processing conditions to create both hydrophobic and hydrophilic surfaces.

### SUMMARY

According to a first aspect, there is provided a method of creating a heat pipe or vapor chamber, the method comprising: providing a substrate comprising a radio frequency (RF) compatible material; applying a first laser treatment to a first section of the substrate to form features on a surface of the substrate in the first section, wherein the first laser treatment comprises a first laser dosage; and applying a second laser treatment to a second section of the substrate to form features on the surface of the substrate in the second section, wherein the second laser treatment comprises a second laser dosage different than the first laser dosage.

The first laser dosage may be in a range of 50 J/cm2 to 100 J/cm2.

The second laser dosage may be in a range of .25 J/cm2 to 45 J/cm2.

The substrate may comprise one or more of poly(methyl methacrylate) (PMMA) based polymers, polysulfone (PSF) based polymers, azobenzene, or polytetrafluoroethylene.

The first laser treatment and the second laser treatment may be applied by a femtosecond laser.

The method may further comprise enclosing at least the surface of the substrate within a sealed housing with a working fluid to form at least one of the heat pipe or vapor chamber. The working fluid may comprise a polar fluid. The working fluid may comprise water.

According to a second aspect, there is provided a heat pipe comprising: a first substrate comprising (i) a radio frequency (RF) compatible material and (ii) a plurality of features on a surface of the first substrate; an evaporator portion having a first section of the surface comprising a polar polarity; a condenser portion having a second section of the surface comprising a non-polar polarity; a second substrate bonded to the first substrate; and a working fluid between the first substrate and the second substrate, wherein the working fluid comprises a polar fluid.

The first section of the surface may be treated with a first laser dosage in a range of 50 J/cm2 to 100 J/cm2 to create the polar polarity.

The first laser dosage may be applied by a femtosecond laser.

The second section of the surface may be treated with a second laser dosage in a range of .25 J/cm2 to 45 J/cm2 to create the non-polar polarity.

The second laser dosage may be applied by a femtosecond laser.

At least one of the first substrate or the second substrate may comprise one or more of poly(methyl methacrylate) (PMMA) based polymers, polysulfone (PSF) based polymers, azobenzene, or polytetrafluoroethylene.

The working fluid may comprise water.

According to a third aspect, there is provided a wearable device comprising an electronic device, wherein the electronic device comprises at least one heat pipe according to the second aspect.

### BRIEF DESCRIPTION OF THE DRAWINGS

The detailed description is described with reference to the accompanying figures. In the figures, the left-most digit(s) of a reference number identifies the figure in which the reference number first appears. The use of the same reference numbers in different figures indicates similar or identical components or features.
FIG. 1A schematically illustrates a substrate for a heat pipe or vapor chamber, in accordance with an example of the present disclosure.
FIG. 1B shows a graph illustrating a relationship of surface contact angle in response to laser dosage a relationship of surface roughness in response to laser dosage.
FIGs. 2A and 2B schematically illustrate the substrate of FIG. 1A and a heat pipe or vapor chamber including the substrate of FIG. 1A in various stages of manufacture, in accordance with an example of the present disclosure.
FIG. 3 is a simplified schematic diagram of an example structure incorporating a heat pipe or vapor chamber, in accordance with an example of the present disclosure.
FIG. 4 illustrates a flow diagram of an example method that illustrates aspects of techniques in accordance with examples as described herein.

### DETAILED DESCRIPTION

The techniques, systems, and arrangements described herein provide unique heat pipe fabrication techniques, whereby wettability of surfaces (hydrophilicity and hydrophobicity) made of materials such as polymers, e.g., poly(methyl methacrylate) (PMMA) based polymers, polysulfone (PSF) based polymers, azobenzene, polytetrafluoroethylene, etc., may be modulated and controlled through a laser treatment or an ultra-violet (UV) treatment. For example, a low-pressure mercury vapor lamp at 184.9 nanometers (nm) or 253.7 nm may be used. Such treatment may be performed for about 1 minute to about 35 minutes depending on the substrate material. The techniques described herein may be used in connection with any electronic device in which it is desirable to transfer heat from one area to another by using one or more heat pipes, vapor chambers, thermal spreaders, and other thermal solutions. By way of example and not limitation, types of electronic devices in which the techniques, systems, and arrangements described herein can be used include wearable devices such as extended reality devices (e.g., augmented reality, virtual reality, mixed reality, etc.), a pair of glasses, such as AR/VR glasses or smart glasses, a head-mounted display (e.g., headset, glasses, helmet, visor, etc.), a suit, a glove (e.g., a haptic glove), a wrist wearable (e.g., watch, wrist band, fitness tracker, etc.), or any combination of these, a handheld electronic device (e.g., tablet, phone, handheld gaming device, controller, etc.), a portable electronic device (e.g., laptop), or a stationary electronic device (e.g., desktop computer, television, set top box, a vehicle electronic device).

This disclosure describes heat pipes, vapor chambers, thermal spreaders, and other thermal solutions (collectively referred to herein as "heat pipes"). Throughout this disclosure, unless specifically described to the contrary, techniques described for construction of a heat pipe can be used for construction of vapor chambers, thermal spreaders, and/or other thermal solutions, and vice versa. In some examples, the heat pipes described herein may be flexible and suitable to transfer heat in devices that bend or flex during use (e.g., within a flexible display, within a glove or other piece of apparel, within a strap or band of a headset, within a flexible frame or temple arm of a pair of glasses, passing through a hinge such as a laptop hinge or a hinge of a pair of glasses, etc.). In such examples of flexible heat pipes, the heat pipes may be formed at least in part of a flexible material, such as a polymer material.

For example, using a laser (e.g., femtosecond laser) with a different dosage (a range of, for example, 50 J/cm² to 100 J/cm²) in an evaporator portion of a heat pipe compared to the condenser portion of a heat pipe (a range of, for example, .25 J/cm² to 45 J/cm²), polymers such as, for example, poly(methyl methacrylate) (PMMA) based polymers, polysulfone (PSF) based polymers, azobenzene, polytetrafluoroethylene, etc., may be chemically altered to have a different surface energy. Additionally, a different focus distance of the femtosecond laser may be used in addition to, or instead of, the different dosages of laser energy. In examples, the focus distance may range from about 0.1 mm to a few millimeters depending on the substrate material.

In examples, a method of making a substrate for a heat pipe or vapor chamber may include providing a substrate comprising a radio frequency compatible material. In examples, a first laser treatment may be applied to a first section of the substrate to form features on a surface of the substrate in the first section. The first laser treatment may comprise a first laser dosage. In examples, a second laser treatment may be applied to a second section of the substrate to form features on the surface of the substrate in the second section. The second laser treatment may comprise a second laser dosage different than the first laser dosage.

In some examples, the first laser dosage may be in a range of 50 J/cm² to 100 J/cm². In some examples, the second laser dosage may be in a range of .25 J/cm² to 45 J/cm². In examples, the first laser treatment and the second laser treatment may be applied by a femtosecond laser.

In examples, the substrate may comprise one or more of poly(methyl methacrylate) (PMMA) based polymers, polysulfone (PSF) based polymers, azobenzene, or polytetrafluoroethylene.

In examples, a pitch of the features may be in a range of 50 microns to 200 microns. In some examples, a first pitch of the features in the first section may be in a range of 50 microns to 100 microns and a second pitch of the features in the second section of the substrate may be in a range of 100 microns to 200 microns. In some examples, the first pitch may increase from 50 microns to 100 microns along a longitudinal direction from the first section to the second section across the substrate and the second pitch may increase from 100 microns to 200 microns in the longitudinal direction across the substrate.

In examples, the method may further include enclosing at least the surface of the substrate within a sealed housing with a working fluid to form at least one of the heat pipe or vapor chamber. In examples, the working fluid may comprise a polar fluid. For example, upon assembly of a heat pipe or vapor chamber, the interior of the heat pipe or vapor chamber may be evacuated to obtain a near vacuum (e.g., having pressure less than about 10⁻³ Torr in some examples). In examples, a small amount of water or other polar working fluid (e.g., 0.1 grams to 1 gram in some examples) may be introduced into the interior of the heat pipe or vapor chamber. In examples, the working fluid may be introduced after the heat pipe or vapor chamber has been evacuated to near vacuum. In examples, the working fluid may be water, acetone, ammonia, glycol/water solution, dielectric coolants, alcohols, liquid nitrogen, mercury, magnesium, potassium, sodium, lithium, silver, methanol, or any combination thereof.

In examples, a heat pipe may include a first substrate comprising (i) a radio frequency (RF) compatible material and (ii) a plurality of features on a surface of the first substrate. The heat pipe may also include an evaporator portion having a first section of the surface comprising a polar polarity. The heat pipe may additionally include a condenser portion having a second section of the surface comprising a non-polar polarity. The heat pipe may also include a second substrate bonded to the first substrate. The heat pipe may further include a working fluid between the first substrate and the second substrate, wherein the working fluid comprises a polar fluid.

In examples, at least one of the first substrate or the second substrate comprises one or more of poly(methyl methacrylate) (PMMA) based polymers, polysulfone (PSF) based polymers, azobenzene, or polytetrafluoroethylene.

In examples, a pitch of the features is in a range of 50 microns to 200 microns. In some examples, a first pitch of the features in the evaporator portion is in a range of 50 microns to 100 microns and a second pitch of the features in the condenser portion is in a range of 100 microns to 200 microns. In some examples, the first pitch increases from 50 microns to 100 microns along a longitudinal direction from the evaporator portion to the condenser portion across the first substrate and the second pitch increases from 100 microns to 200 microns in the longitudinal direction across the first substrate.

In examples, a wearable device includes an electronic device, the electronic device including at least one heat pipe. The at least one heat pipe may include a first substrate comprising (i) a radio frequency (RF) compatible material and (ii) a plurality of features on a surface of the first substrate. The at least one heat pipe may also include an evaporator portion having a first section of the surface comprising a polar polarity. The at least one heat pipe may additionally include a condenser portion having a second section of the surface comprising a non-polar polarity. The at least one heat pipe may also include a second substrate bonded to the first substrate. The at least one heat pipe may further include a working fluid between the first substrate and the second substrate, wherein the working fluid comprises a polar fluid.

In examples, at least one of the first substrate or the second substrate comprises one or more of poly(methyl methacrylate) (PMMA) based polymers, polysulfone (PSF) based polymers, azobenzene, or polytetrafluoroethylene.

In examples, a pitch of the features is in a range of 50 microns to 200 microns. In some examples, a first pitch of the features in the evaporator portion is in a range of 50 microns to 100 microns and a second pitch of the features in the condenser portion is in a range of 100 microns to 200 microns. In some examples, the first pitch increases from 50 microns to 100 microns along a longitudinal direction from the evaporator portion to the condenser portion across the substrate and the second pitch increases from 100 microns to 200 microns in the longitudinal direction across the substrate.

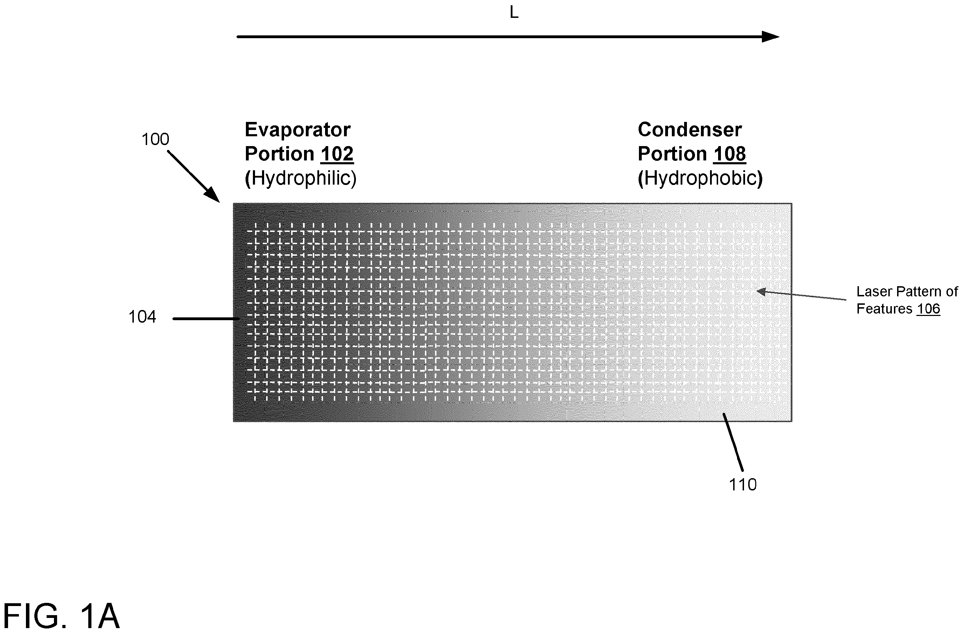

FIG. 1A schematically illustrates a substrate 100 for a heat pipe or vapor chamber. The substrate 100 is illustrated as an elongated substrate or rectangle. However, the substrate 100 may be sized and shaped to any desired dimensions for a given design architecture. By way of example and not limitation, a heat pipe or vapor chamber may be elongated, arcuate, curved with continuous or variable radii, substantially planar substrates. In examples, the substrate 100 comprises a radio frequency (RF) compatible material, e.g., a material that does not materially attenuate or otherwise interfere with RF signals, i.e. a material that does not interfere with radio signals such as radio signals that are received by and/or emanate from an antenna. For example, and without limitation, the substrate 100 may comprise a polymer, e.g., poly(methyl methacrylate) (PMMA) based polymers, polysulfone (PSF) based polymers, azobenzene, polytetrafluoroethylene, etc. However, in other examples, any of the other materials described herein may be used.

The substrate 100 includes a first portion or section that serves as an evaporator portion 102 in a heat pipe or vapor chamber and has a hydrophilic surface 104. The evaporator portion 102 includes features 106. In some examples, channels may be defined within the evaporator portion 102 to provide protrusions similar to the features.

The substrate 100 also includes a second portion or section that that serves as a condenser portion 108 in a heat pipe or vapor chamber and has a hydrophobic surface 110. The condenser portion 108 includes features 106. In some examples, channels may be defined within the condenser portion 108 to provide protrusions similar to the features.

In examples, one or more features 106 may be formed only over a portion (less than all) of the substrate 100. In examples, one or more features 106 may be formed over the whole surface of the substrate 100. In examples, one or more features 106 may be formed to extend along the full length of the surfaces 104, 110 of the substrate 100. In examples, one or more features 106 may be formed to extend only partially along a length (less than the full length) of the surfaces 104, 110 of the substrate 100. In examples, one or more features may extend partially along the length (less than the full length) of the surfaces 104, 110 of the substrate 100 and other one or more features 106 may extend along the full length of the surfaces 104, 110 of the substrate 100.

In examples, a pitch of the features 106 is in a range of 50 microns to 200 microns. In some examples, a pitch of the features 106 in the evaporator portion 102 is in a range of 50 microns to 100 microns and a pitch of the features in the condenser portion 108 is in a range of 100 microns to 200 microns. In some examples, the pitch of the features 106 in the evaporator portion 102 increases from 50 microns to 100 microns along a longitudinal direction L across the substrate 100 and the pitch of the features in the condenser portion 108 increases from 100 microns to 200 microns in the longitudinal direction L across the substrate. Higher pitch of the features 106 leads to more hydrophobicity (in most scenarios).

In some examples, the features 106 in the evaporator portion 102 may be created using a laser process. The features 106 may be created using a femtosecond laser that provides a high laser dosage in a range of, for example, 50 J/cm² to 100 J/cm² to treat the surface 104 in the evaporator portion 102. Additionally, an oxidation process may be performed on and/or between the features 106 in the evaporator portion 102 to form an oxide. In some examples, the features 106 may be created using techniques, systems, and processes as described in co-pending U.S. patent application no. 17/559,949, assigned to Meta Platforms Technologies, LLC, Menlo Park, CA, the entirety of which is incorporated herein by reference for all purposes.

In particular, in the evaporator portion 102, oxides exposed to air (thin passivation layers or those formed by the laser processing), have unsaturated oxygen atoms in their surface. Therefore, the hydroxylation may take place mainly by the adsorption of atmospheric water (heterolytic dissociation). This is a reason for the hydrophilic nature of most of the surfaces in the evaporator portion 102, and also the freshly prepared laser patterned features 106. In examples, the surface 104 of the evaporator portion 102 has a low contact angle, e.g., less than about 10 degrees, making it hydrophilic.

In examples, the features 106 in the condenser portion 108 may be created using a femtosecond laser that provides a low laser dosage in a range of, for example, .25 J/cm² to 45 J/cm² to treat the surface 110 in the condenser portion 108. In some examples, the features 106 may be created using techniques, systems, and processes as described in co-pending U.S. patent application no. 17/559,949, assigned to Meta Platforms Technologies, LLC, Menlo Park, CA. In examples, the hydrophobic surface 110 of the condenser portion 108 has a high contact angle, e.g., greater than about 130 degrees.

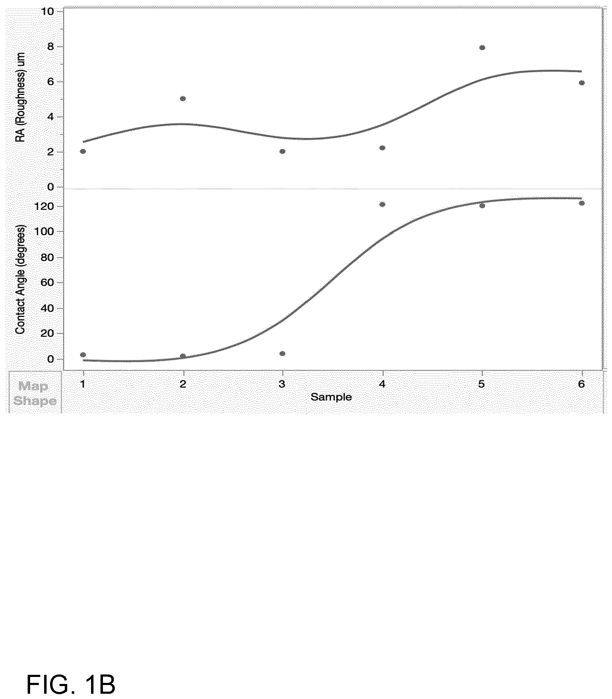

Thus, using a femtosecond laser with a different dosage in the evaporator portion 102 (a range of, for example, 50 J/cm² to 100 J/cm²) compared to the condenser portion 108 (a range of, for example, .25 J/cm² to 45 J/cm²), polymers such as, for example, poly(methyl methacrylate) (PMMA) based polymers, polysulfone (PSF) based polymers, azobenzene, polytetrafluoroethylene, etc., may be chemically altered to have a different surface energy. Additionally, a different focus time of the femtosecond laser may be used in addition to, or instead of, the different dosages of laser energy. FIG. 1B shows a graph illustrating a relationship of surface contact angle in response to laser dosage a relationship of surface roughness in response to laser dosage.

Additionally, Table 1 below illustrates a relationship of a percentage of carbon (C1) or oxygen (O1) after a femtosecond laser dosage on the substrate 100 when the substrate 100 comprises PMMA. As can be seen, when a low dosage is applied, C1 of the C-C chemical bond increases from 14% in the raw PMMA to 20%. Likewise, when a high dosage is applied, the O1 of the O=C chemical bond increases from 11% in the raw PMMA to 30% and the O1 of the O-C chemical bond increases from 11% in the raw PMMA to 21%. These results were obtained using an x-ray photoelectron spectrometry (XPS) test (relative amount of oxygen/carbon functional group. As is known, XPS is a surface-sensitive quantitative spectroscopic technique based on the photoelectric effect that can identify the elements that exist within a material (elemental composition) or are covering its surface, as well as their chemical state, and the overall electronic structure and density of the electronic states in the material. XPS is a powerful measurement technique because it not only shows what elements are present, but also what other elements to which they are bonded. The technique can be used in line profiling of the elemental composition across the surface, or in-depth profiling when paired with ion-beam etching. It is often applied to study chemical processes in the materials in their as-received state and/or after cleavage, scraping, exposure to heat, reactive gasses or solutions, laser treatment, ultraviolet light treatment, or during ion implantation.

**Table 1**

| **Polarity** | **Chemical Bond** | **Raw PMMA** | **High Dosage (J/cm2)** | **Low Dosage (J/cm2)** |
|---|---|---|---|---|
| Non-polar | C1 s. C-H | 40 | 29.78 | 40 |
| Non-polar | C1 s. C-C | 14 | 1.38 | 20 |
| Polar | C1 s. C-O | 13 | 11 | 11 |
| Polar | C1 s. O-C=C | 10 | 6 | 8 |
| Polar | O1 s. O=C | 11 | 30 | 12 |
| Polar | O1 s. O-C | 11 | 21 | 9 |

In examples, the condenser portion 108 may be separate from the evaporator portion 102. In other examples, the condenser portion 108 may at least partially overlap the evaporator portion 102. In some examples, there may be more than two different portions 102, 108. For example, there may be three or more portions, and each portion may be treated with a different laser dosage applied and/or a different feature pitch so that each portion has a different degree of hydrophilicity/hydrophobicity between the evaporator portion 102 and the condenser portion 108. Also, in examples, the laser dosage may change gradually and/or continuously from the evaporator portion 102 to the condenser portion 108 such that there are no discrete "portions" but rather the hydrophilicity/hydrophobicity is a gradient that changes between the evaporator portion 102 and the condenser portion 108.

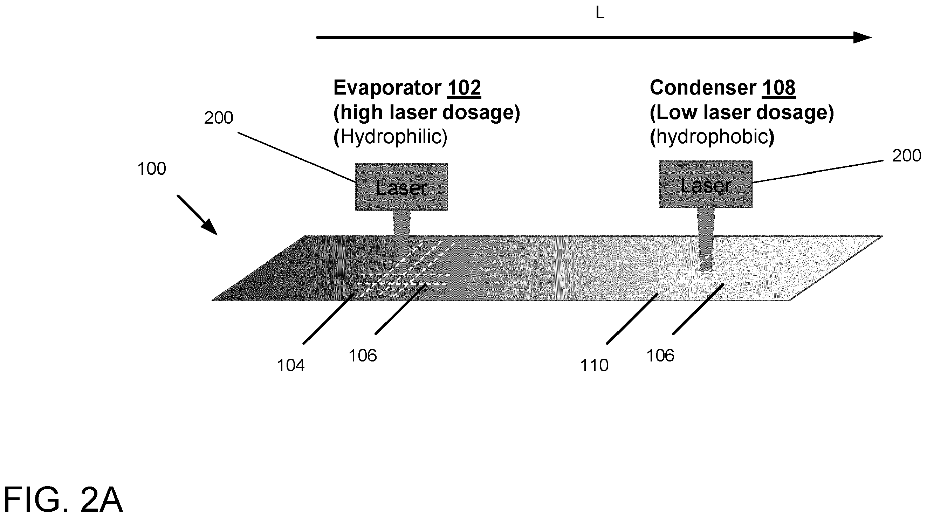

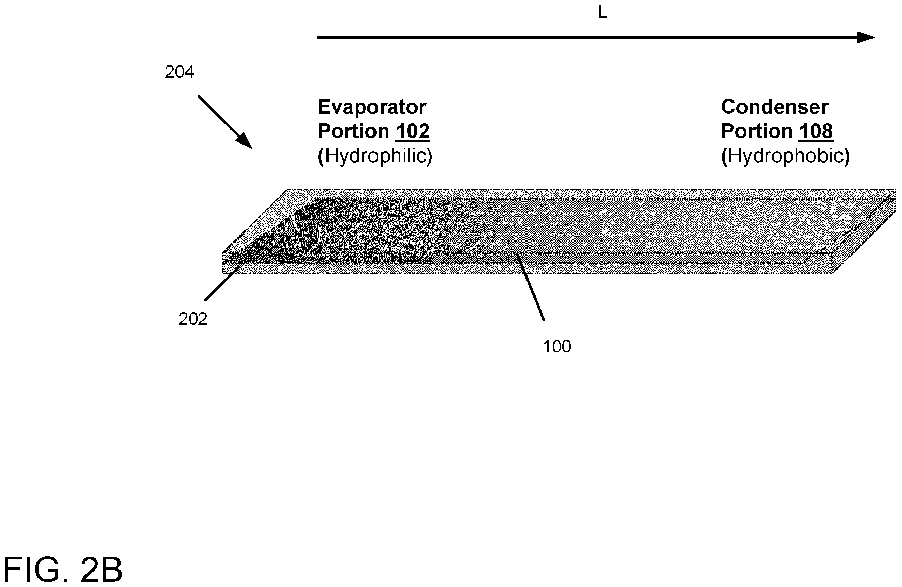

Referring to FIGs. 2A and 2B, in examples, the features 106 are created using a laser process with a laser 200, as previously noted. Thus, a first operation includes a laser process using the laser 200 to create a hydrophilic surface on the surface 104 for all or a portion of the "floor plan" on the substrate 100 in the evaporator portion 102 and creating the features 106. In examples, the features 106 in the condenser portion 108 may be created using the laser 200 in the form of a femtosecond laser that provides a high laser dosage in a range of, for example, 50 J/cm² to 100 J/cm². A second operation includes a laser process using the laser 200 to create a hydrophobic surface on the surface 110 for all or a portion of the "floor plan" on the substrate 100 in the condenser portion 108 and creating the features 106. In examples, the features 106 in the condenser portion 108 may be created using the laser 200 in the form of a femtosecond laser that provides a low laser dosage in a range of, for example, .25 J/cm² to 45 J/cm².

As can be seen in FIG. 2B, a second substrate 202 may be bonded to the substrate 100 over at least the features 106 to provide a sealed housing. In examples, the second substrate 202 may comprise RF compatible polymers such as, for example, poly(methyl methacrylate) (PMMA) based polymers, polysulfone (PSF) based polymers, azobenzene, polytetrafluoroethylene, etc. A polar working fluid (not illustrated) is disposed in between the substrates 100, 202 to form a heat pipe or vapor chamber 204. For example, upon assembly of a heat pipe or vapor chamber 204, the interior of the heat pipe or vapor chamber 204 may be evacuated to obtain a near vacuum (e.g., having pressure less than about 10⁻³ Torr in some examples). In examples, a small amount of water or other polar working fluid (e.g., 0.1 grams to 1 gram in some examples) may be introduced into the interior of the heat pipe or vapor chamber 204. In examples, the polar working fluid may be introduced after the heat pipe or vapor chamber 204 has been evacuated to near vacuum. In examples, the polar working fluid may be water, acetone, ammonia, glycol/water solution, dielectric coolants, alcohols, liquid nitrogen, mercury, magnesium, potassium, sodium, lithium, silver, methanol, or any combination thereof.

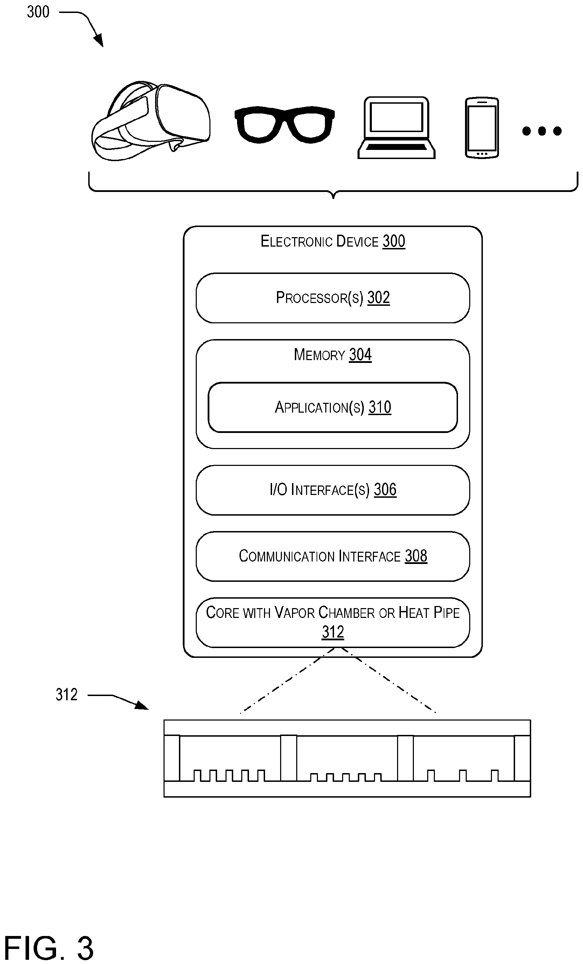

FIG. 3 illustrates an example electronic device 300 in which a heat pipe or vapor chamber as manufactured in accordance with this description may be employed. The electronic device 300 may be representative of a head-mounted device, such as an extended reality visor or glasses, a laptop computer, a mobile device such as a tablet or mobile phone, or any other electronic device such as those described throughout this application. As shown, the electronic device 300 includes one or more electronic components such as processors 302, memory 304, input/output interfaces 306 (or "I/O interfaces 306"), and communication interfaces 308, which may be communicatively coupled to one another by way of a communication infrastructure (e.g., a bus, traces, wires, etc.). While the electronic device 300 is shown in FIG. 3 having a particular configuration, the components illustrated in FIG. 3 are not intended to be limiting. The various components can be rearranged, combined, and/or omitted depending on the requirements for a particular application or function. Additional or alternative components may be used in other examples.

In some examples, the processor(s) 302 may include hardware for executing instructions, such as those making up a computer program or application. For example, to execute instructions, the processor(s) 302 may retrieve (or fetch) the instructions from an internal register, an internal cache, the memory 304, or other computer-readable media, and decode and execute them. By way of example and not limitation, the processor(s) 302 may comprise one or more central processing units (CPUs), graphics processing units (GPUs), holographic processing units, microprocessors, microcontrollers, integrated circuits, programmable gate arrays, or other hardware components usable to execute instructions.

The memory 304 is an example of computer-readable media and is communicatively coupled to the processor(s) 302 for storing data, metadata, and programs for execution by the processor(s) 302. In some examples, the memory 304 may constitute non-transitory computer-readable media such as one or more of volatile and non-volatile memories, such as Random-Access Memory ("RAM"), Read-Only Memory ("ROM"), a solid-state disk ("SSD"), Flash, Phase Change Memory ("PCM"), or other types of data storage. The memory 304 may include multiple instances of memory, and may include internal and/or distributed memory. The memory 304 may include removable and/or non-removable storage. The memory 304 may additionally or alternatively include one or more hard disk drives (HDDs), flash memory, Universal Serial Bus (USB) drives, or a combination these or other storage devices.

As shown, the electronic device 300 includes one or more I/O interfaces 306, which are provided to allow a user to provide input to (such as touch inputs, gesture inputs, keystrokes, voice inputs, etc.), receive output from, and otherwise transfer data to and from the electronic device 300. Depending on the particular configuration and function of the electronic device 300, the I/O interface(s) 306 may include one or more input interfaces such as keyboards or keypads, mice, styluses, touch screens, cameras, microphones, accelerometers, gyroscopes, inertial measurement units, optical scanners, other sensors, controllers (e.g., handheld controllers, remote controls, gaming controllers, etc.), network interfaces, modems, other known I/O devices or a combination of such I/O interface(s) 306. Touch screens, when included, may be activated with a stylus, finger, thumb, or other object. The I/O interface(s) 306 may also include one or more output interfaces for presenting output to a user, including, but not limited to, a graphics engine, a display (e.g., a display screen, projector, holographic display, etc.), one or more output drivers (e.g., display drivers), one or more audio speakers, and one or more audio drivers. In certain examples, I/O interface(s) 306 are configured to provide graphical data to a display for presentation to a user. The graphical data may be representative of one or more graphical user interfaces and/or any other graphical content as may serve a particular implementation. By way of example, the I/O interface(s) 306 may include or be included in a wearable device, such as a head-mounted display (e.g., headset, glasses, helmet, visor, etc.), a suit, gloves, a watch, or any combination of these, a handheld electronic device (e.g., tablet, phone, handheld gaming device, etc.), a portable electronic device (e.g., laptop), or a stationary electronic device (e.g., desktop computer, television, set top box, a vehicle electronic device). In some examples, the I/O interface(s) 306 may be configured to provide an extended reality environment or other computer-generated environment.

The electronic device 300 may also include one or more communication interface(s) 308. The communication interface(s) 308 can include hardware, software, or both. In examples, communication interface(s) 308 may provide one or more interfaces for physical and/or logical communication (such as, for example, packet-based communication) between the electronic device 300 and one or more other electronic devices or one or more networks. As an example, and not by way of limitation, the communication interface(s) 308 may include a network interface controller (NIC) or network adapter for communicating with an Ethernet or other wire-based network and/or a wireless NIC (WNIC) or wireless adapter for communicating with a wireless network, such as a WI-FI adapter. In examples, communication interface(s) 308 can additionally include a bus, which can include hardware (e.g., wires, traces, radios, etc.), software, or both that communicatively couple components of electronic device 300 to each other. In examples, the electronic device 300 may include additional or alternative components that are not shown, such as, but not limited to, a power supply (e.g., batteries, capacitors, etc.), a housing or other enclosure to at least partially house or enclose the chassis and/or any or all of the components.

The memory 304 may store one or more applications 310, which may include, among other things, an operating system (OS), productivity applications (e.g., word processing applications), communication applications (e.g., email, messaging, social networking applications, etc.), games, or the like. The application(s) 310 may be implemented as one or more stand-alone applications, as one or more modules of an application, as one or more plug-ins, as one or more library functions application programming interfaces (APIs) that may be called by other applications, and/or as a cloud-computing model. The application(s) 310 can include local applications configured to be executed locally on the electronic device, one or more web-based applications hosted on a remote server, and/or as one or more mobile device applications or "apps."

In examples, the electronic device 300 may also include a core 312 including one or more heat pipes or vapor chambers to which the other electronic components such as the processor(s) 302, memory 304, I/O interface(s) 306, and/or communication interface(s) 308 can be coupled. In examples, the heat pipe or vapor chamber may be formed integrally with the core 312 and may be configured to dissipate and/or spread heat generated by the one or more other components.

In examples, the heat pipe or vapor chamber of the core 312 may include features and can be made according to the techniques described herein and may be configured to exhibit manufacturing tolerances suitable for mounting precision optical components (e.g., lenses, display screens, mirrors, gratings, optical fibers, light pipes, etc.).

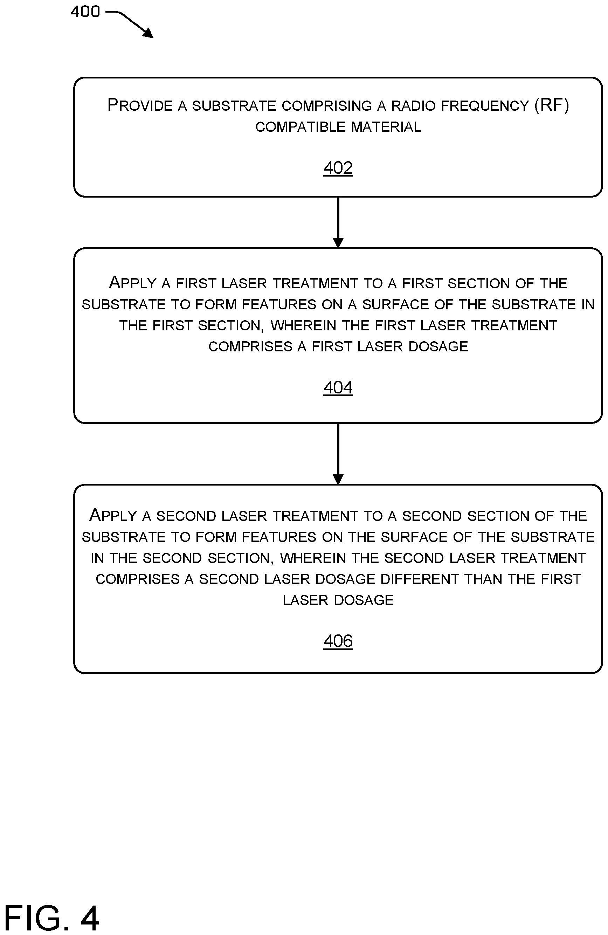

FIG. 4 illustrates a flow diagram of an example method 400 that illustrates aspects of techniques as described herein. It should be appreciated that more or fewer operations might be performed than shown in FIG. 4 and described herein. These operations can also be performed in parallel, or in a different order than those described herein.

FIG. 4 schematically illustrates an example method 400 of manufacturing a substrate for a heat pipe or vapor chamber, e.g., heat pipe or vapor chamber 204 including substrate 100.

At 402, a substrate comprising a radio frequency (RF) compatible material is provided. In some examples, the substrate 100 for a heat pipe or vapor chamber is provided. For example, the substrate 100 comprises a radio frequency (RF) compatible material, e.g., a material that does not interfere with radio signals such as radio signals that are received by and/or emanate from an antenna. For example, and without limitation, the substrate 100 may comprise a polymer, e.g., poly(methyl methacrylate) (PMMA) based polymers, polysulfone (PSF) based polymers, azobenzene, polytetrafluoroethylene, etc.

At 404, a first laser treatment is applied to a first section of the substrate to form features on a surface of the substrate in the first section, wherein the first laser treatment comprises a first laser dosage. In some examples, the features 106 in the evaporator portion 102 may be created using a laser process. The features 106 may be created using a femtosecond laser that provides a high laser dosage in a range of, for example, 50 J/cm² to 100 J/cm². Additionally, an oxidation process may be performed on and/or between the features 106 in the evaporator portion 102 to form an oxide. In some examples, the features 106 may be created using techniques, systems, and processes as described in co-pending U.S. patent application no. 17/559,949, assigned to Meta Platforms Technologies, LLC, Menlo Park, CA. In examples, the hydrophilic surface 104 of the evaporator portion 102 has a low contact angle, e.g., less than about 10 degrees.

At 406, a second laser treatment is applied to a second section of the substrate to form features on the surface of the substrate in the second section, wherein the second laser treatment comprises a second laser dosage different than the first laser dosage. In examples, the features 106 in the condenser portion 108 may be created using a femtosecond laser that provides a low laser dosage in a range of, for example, .25 J/cm² to 45 J/cm². In some examples, the features 106 may be created using techniques, systems, and processes as described in co-pending U.S. patent application no. 17/559,949, assigned to Meta Platforms Technologies, LLC, Menlo Park, CA. In examples, the surface of the condenser portion 108 has a high contact angle, e.g., greater than about 130 degrees, making it hydrophobic.

Although the discussion above sets forth example implementations of the described techniques, other architectures may be used to implement the described functionality and are intended to be within the scope of this disclosure.

Furthermore, although the subject matter has been described in language specific to structural features and/or methodological acts, it is to be understood that the subject matter defined in the appended claims is not necessarily limited to the specific features or acts described. Rather, the specific features and acts are disclosed as exemplary forms of implementing the claims.

## Claims

1. A method of creating a heat pipe or vapor chamber, the method comprising:
providing a substrate comprising a radio frequency, RF, compatible material;
applying a first laser treatment to a first section of the substrate to form features on a surface of the substrate in the first section, wherein the first laser treatment comprises a first laser dosage; and
applying a second laser treatment to a second section of the substrate to form features on the surface of the substrate in the second section, wherein the second laser treatment comprises a second laser dosage different than the first laser dosage.

2. The method of claim 1, wherein the first laser dosage is in a range of 50 J/cm² to 100 J/cm².

3. The method of claim 2, wherein the second laser dosage is in a range of .25 J/cm² to 45 J/cm².

4. The method of any preceding claim, wherein the substrate comprises one or more of poly(methyl methacrylate), PMMA, based polymers, polysulfone, PSF, based polymers, azobenzene, or polytetrafluoroethylene.

5. The method of any preceding claim, wherein the first laser treatment and the second laser treatment are applied by a femtosecond laser.

6. The method of any preceding claim, further comprising:
enclosing at least the surface of the substrate within a sealed housing with a working fluid to form at least one of the heat pipe or vapor chamber, wherein the working fluid comprises a polar fluid.

7. The method of claim 6, wherein the working fluid comprises water.

8. A heat pipe comprising:
a first substrate comprising (i) a radio frequency, RF, compatible material and (ii) a plurality of features on a surface of the first substrate;
an evaporator portion having a first section of the surface comprising a polar polarity;
a condenser portion having a second section of the surface comprising a non-polar polarity;
a second substrate bonded to the first substrate; and
a working fluid between the first substrate and the second substrate, wherein the working fluid comprises a polar fluid.

9. The heat pipe of claim 8, wherein the first section of the surface is treated with a first laser dosage in a range of 50 J/cm² to 100 J/cm² to create the polar polarity.

10. The heat pipe of claim 9, wherein the first laser dosage is applied by a femtosecond laser.

11. The heat pipe of claim 9 or 10, wherein the second section of the surface is treated with a second laser dosage in a range of .25 J/cm² to 45 J/cm² to create the non-polar polarity.

12. The heat pipe of claim 11, wherein the second laser dosage is applied by a femtosecond laser.

13. The heat pipe of any of claims 8 to 12, wherein at least one of the first substrate or the second substrate comprises one or more of poly(methyl methacrylate), PMMA, based polymers, polysulfone, PSF, based polymers, azobenzene, or polytetrafluoroethylene.

14. The heat pipe of any of claims 8 to 13, wherein the working fluid comprises water.

15. A wearable device comprising an electronic device, wherein the electronic device comprises at least one heat pipe according to any of claims 8 to 14.
